# FASCICULE DE BREVET EUROPEEN

(11) **EP 3 226 084 B1**
(45) Date de publication et mention de la délivrance du brevet: **13.01.2021**
(21) Numéro de dépôt: 16162651.0
(22) Date de dépôt: 29.03.2016
(51) Int. Cl.: G04B 19/32, A44C 27/00, C23C 14/12, G04B 37/22, G04B 45/00

(54) **COMPOSANT HORLOGER COLORÉ**
FARBIGE UHRENKOMPONENTE
COLOURED TIMEPIECE COMPONENT

(43) Date de publication de la demande: 04.10.2017
(73) Titulaire: The Swatch Group Research and Development Ltd., 2074 Marin (CH)
(72) Inventeur: Turcotte, Karine, Boucherville, Québec J4B 4Z7 (CA); Hämmerli, Alexandre, 2072 St-Blaise (CH)
(74) Mandataire: Ravenel, Thierry Gérard Louis

(56) Documents cités:
- EP-A2- 2 902 855
- FR-A- 1 335 336
- US-B1- 6 538 959

## Description

### OBJET DE L'INVENTION

La présente invention se rapporte au domaine technique de l'horlogerie. Plus particulièrement, elle se rapporte à un composant horloger et au procédé de dépôt de couches colorées sur ce composant.

### ARRIÈRE-PLAN TECHNOLOGIQUE ET ÉTAT DE LA TECHNIQUE

L'aspect esthétique étant particulièrement important dans l'horlogerie, il est apprécié de colorer ou, du moins, rendre visible certains composants.

Par exemple, un spiral en matériau comme le verre ou le quartz, lorsqu'assemblé sur son balancier, est difficile à observer car transparent. Actuellement, pour palier à cet inconvénient, il est par exemple usiné à partir de substrats non polis qui, grâce à la réflexion diffuse, produisent des pièces plus voyantes. L'ajout d'une ou plusieurs couches colorées permettrait de rendre l'objet visible et esthétiquement attractif.

Pour les aiguilles d'affichage lumineuses, l'illumination sur une gamme étendue de couleurs est réalisée par exemple par injection de lumière provenant d'une LED. Enrober les différentes aiguilles de couches minces colorées distinctes permettrait d'illuminer les aiguilles sur une large gamme de couleurs partant d'une même source lumineuse, par exemple d'une LED blanche.

Des couches luminescentes colorées pourraient également susciter l'intérêt pour des composants illuminés par une source de lumière montée dans la montre ou par une source UV externe ou encore par de l'illumination passive à l'aide de couches à pigments fluorescents ou phosphorescents. Outre la création d'effets esthétiques, cela permettrait de faire du marquage anti-réplique.

De manière traditionnelle, la coloration s'effectue à l'aide de laques et résines colorées, ou par couches minces interférométriques, ou encore par pulvérisation cathodique de colorants à base d'oxydes et de sulfures de métaux.

Ainsi, on connaît du document EP 2 717 103 un procédé de dépôt de pigments inorganiques sur des composants horlogers. Les pigments inorganiques ont pour caractéristique de former une couche opaque sur le substrat. Or, il peut s'avérer avantageux pour certaines applications de garder l'état de surface du substrat visible après dépôt. Cela permet, par exemple, de moduler la brillance de la couche déposée selon l'état de surface, que le substrat soit poli ou non. En outre, cela permet de garder visible une texture préalablement formée sur le substrat ou encore d'obtenir un effet de profondeur lorsque le substrat est transparent.

Le document EP 2 902 855 décrit un composant d'habillage horloger comprenant un substrat revêtu sur une face d'une couche de fond revêtue à son tour dans certaines régions d'un matériau tel qu'un colorant.

Le document FR 1 335 336 décrit un procédé de revêtement d'objet avec des couches colorées absorbant la lumière.

Le document US 6 538 959 décrit un cadran de montre recouvrant une cellule solaire.

### RÉSUMÉ DE L'INVENTION

La présente invention propose un nouveau procédé de coloration pour composants horlogers permettant de visualiser l'état de surface du substrat après dépôt.

A cette fin, un composant horloger et un procédé selon les revendications annexées sont proposés.

### BRÈVE DESCRIPTION DES FIGURES

Les caractéristiques et avantages de la présente invention apparaîtront à la lecture de la description détaillée ci-dessous faisant référence aux figures suivantes.

La figure 1 représente de manière connue l'équipement mis en œuvre pour réaliser le procédé de dépôt selon l'invention.

La figure 2 représente, à titre d'exemple, une vue partielle d'un cadran présentant des textures au niveau des ouvertures dédiées aux chronographes. Après dépôt d'une couche colorée selon l'invention, la texture est toujours visible au travers de la couche déposée.

La figure 3 représente une glace après dépôt d'un logo en pigments organiques selon l'invention.

### Légende

- (1): Substrat
- (2): Nacelle
- (3): Chambre
- (4): Préparation de pigments
- (5): Source thermique
- (6): Système de pompage sous vide
- (7): Ouverture dédiée au chronographe
- (8): Cadran
- (9): Glace

### DESCRIPTION DÉTAILLÉE DE L'INVENTION

La présente invention se rapporte à un procédé de dépôt de couches colorées sur des composants horlogers. Selon l'invention, le dépôt s'effectue par évaporation sous vide. La présente invention vise plus particulièrement à déposer des pigments organiques qui ont pour avantage de former une couche mince semi-transparente sur le substrat, ce qui permet de distinguer la structure et/ou l'état de surface du substrat.

Le substrat peut être tout composant horloger où un effet esthétique est désiré. Il peut s'agir de composants transparents ou semi-transparents en quartz, verre ou céramique. Par exemple, il peut s'agir d'un spiral, d'une aiguille, d'appliques, d'une glace, d'un réhaut, d'un pont, d'un rouage, ou de tout composant agissant comme guide de lumière ou d'un fond de montre transparent. Il peut également s'agir de substrats opaques tels qu'un cadran, un fond de montre, un organe du mouvement, etc.

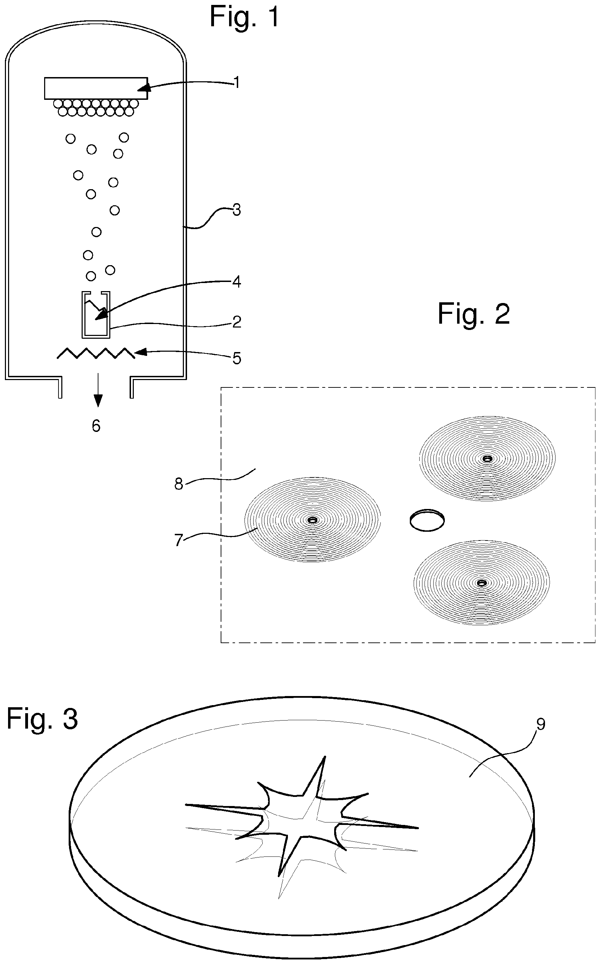

Les couches colorées d'épaisseur comprise entre 400 et 1500 nm sont réalisées par évaporation thermique. La figure 1 représente schématiquement l'équipement. De manière connue, le ou les substrats 1 sont fixés sur un support et la nacelle 2 est placée au fond de la chambre 3. Après création du vide, la nacelle comprenant la préparation de pigments 4 est chauffée par un filament électrique 5. La préparation de pigments est alors sublimée et déposée sur le substrat. Le dépôt se fait de manière homogène en contrôlant l'épaisseur de la couche déposée et qui est typiquement mesurée in-situ à l'aide d'une microbalance à quartz.

Les pigments organiques sont des molécules de carbone associées à des atomes d'hydrogène, azote ou oxygène. La liste suivante non exhaustive fournit des exemples de pigments utilisés dans le procédé selon l'invention : quinophthalone, condensation disazo, sel monosodique (monoazo), isoindolinone, isoindoline, composé azoïque, ptéridine, diarylide, diketopyrrolopyrrole, benzimidazolone, pérylène, β-naphtol (Sr), β-naphtol (Ba), anthraquinone, quinacridone, BONA (Sr), BONA (Ca), dioxazine, Cu-phthalocyanine. Selon l'invention, des pigments luminescents peuvent également être ajoutés aux pigments colorants.

Les pigments sous forme de poudre, avec typiquement une taille de particules entre 5 et 60 µm, sont répartis dans un solvant tel que de l'alcool isopropylique ou de l'acétate de butyle. Le mélange est cuit au four à basse température, typiquement dans une gamme 40-120°C et, de préférence, à une température proche de 50 °C, pendant quelques heures afin d'évaporer le solvant et d'obtenir ainsi un mélange bien compact. Le mélange ainsi préparé est évaporé sous vide. Selon l'invention, une seule couche est déposée ou plusieurs couches de teintes différentes sont superposées afin de moduler la couleur et les effets optiques. Optionnellement, une couche mince dure de protection finale peut être déposée, notamment une couche d'oxydes déposée par pulvérisation cathodique.

Comme déjà mentionné, le dépôt d'une couche de pigments organiques permet de visualiser la structure ou l'état de surface du substrat. Ainsi, si le substrat est poli, la couche apparait brillante alors que s'il est dépoli, elle apparait mate. Si le substrat présente une texture ou, de manière générale, un motif avec ou sans relief, le motif est toujours visible après dépôt. Dans l'exemple illustré à la figure 2, des cercles concentriques ont été usinés dans le métal au niveau des ouvertures 7 dédiées aux chronographes sur le cadran 8 et, ce, afin de créer un effet toupie. Après dépôt, le motif reste visible de même que le fini poli et brillant du métal. Des essais réalisés sur des cadrans métalliques présentant une texture ont également donné de très bons résultats. Il est ainsi envisageable de générer toute sorte de motif sur le substrat et de garder ce motif visible après coloration.

En outre, un effet de profondeur ou de superposition peut être obtenu en colorant des composants transparents. On peut ainsi obtenir un bel effet esthétique en déposant un logo coloré sur un substrat transparent comme schématisé à la figure 3. Il est également envisageable de produire un effet "faux" rubis ou autre pierre précieuse par le dépôt de couches colorées sur le substrat transparent ou semi-transparent.

Il est aussi envisageable de déposer des couches de couleur différentes en fonction de la position sur le substrat, ainsi que des motifs ou structures colorés.

Pour finir, on précisera que les pigments organiques offrent un pouvoir colorant et une palette de couleurs supérieurs à ceux des pigments minéraux, ce qui permet d'obtenir un très bon rendu visuel.

## Revendications

1. Composant horloger comportant sur au moins une partie de sa surface un revêtement formé d'une ou plusieurs couches de pigments organiques, **caractérisé en ce qu'**il comporte sur au moins une partie de sa surface un motif avec ou sans relief visible au travers de la ou des couches.

2. Composant horloger selon la revendication 1, comportant plusieurs couches composées respectivement de pigments différents, lesdites couches étant superposées ou positionnées à des endroits distincts sur le composant.

3. Composant horloger selon la revendication 1 ou 2, dans lequel les pigments sont choisis parmi une liste constituée de quinophthalone, condensation disazo, sel monosodique, isoindolinone, isoindoline, composé azoïque, ptéridine, diarylide, diketopyrrolopyrrole, benzimidazolone, pérylène, β-naphtol (Sr), β-naphtol (Ba), anthraquinone, quinacridone, BONA (Sr), BONA (Ca), dioxazine et de Cu-phthalocyanine.

4. Composant horloger selon l'une quelconque des revendications précédentes, dans lequel la ou les couches comportent en outre un pigment luminescent.

5. Composant selon l'une quelconque des revendications précédentes, étant un composant transparent ou semi-transparent tel qu'un spiral, une aiguille, une glace ou un fond de montre.

6. Composant horloger selon l'une quelconque des revendications 1 à 4, étant un composant opaque tel qu'un cadran ou un organe du mouvement.

7. Montre comprenant un composant horloger selon l'une quelconque des revendications précédentes.

8. Procédé de revêtement d'un composant horloger comportant sur au moins une partie de sa surface un motif avec ou sans relief par évaporation sous vide de pigments organiques, lequel motif est visible au travers dudit revêtement.

9. Procédé selon la revendication 8, dans lequel les pigments sont sélectionnés parmi la liste constituée de quinophthalone, condensation disazo, sel monosodique, isoindolinone, isoindoline, composé azoïque, ptéridine, diarylide, diketopyrrolopyrrole, benzimidazolone, pérylène, β-naphtol (Sr), β-naphtol (Ba), anthraquinone, quinacridone, BONA (Sr), BONA (Ca), dioxazine et de Cu-phthalocyanine.

10. Procédé selon la revendication 8 ou 9, dans lequel les pigments sont mélangés avec un solvant et chauffés dans une gamme de température comprise entre 40 et 120°C, et de préférence autour de 50°C, pour former un mélange compact de pigments avant sublimation.

11. Procédé selon l'une quelconque des revendications 8 à 10, comprenant, après dépôt des pigments organiques, une étape de dépôt d'une couche de protection finale par pulvérisation cathodique.

12. Procédé selon la revendication 11, dans lequel la couche de protection finale est une couche d'oxydes.

## Patentansprüche

1. Uhrenkomponente, umfassend auf mindestens einem Teil seiner Oberfläche einen Überzug, der von einer oder mehreren Schichten organischer Pigmente gebildet ist, **dadurch gekennzeichnet, dass** sie auf mindestens einem Teil ihrer Oberfläche ein Motiv mit oder ohne Relief aufweist, das durch die Schicht(en) sichtbar ist.

2. Uhrenkomponente nach Anspruch 1, aufweisend mehrere Schichten, die jeweils aus unterschiedlichen Pigmenten zusammengesetzt sind, wobei die Schichten übereinanderliegen oder an unterschiedlichen Stellen auf der Komponente positioniert sind.

3. Uhrenkomponente nach Anspruch 1 oder 2, wobei die Pigmente aus einer Liste ausgewählt sind, die aus Cinophthalon, Disazokondensation, Mononatriumsalz, Isoindolinon, Isoindolin, Azoverbindung, Pteridin, Diarylid, Diketopyrrolopyrrol, Benzimidazolon, Perylen, β-Naphthol (Sr), β-Naphthol (Ba), Anthrachinon, Chinacridon, BONA (Sr), BONA (Ca), Dioxazin und Cu-Phthalocyanin besteht.

4. Uhrenkomponente nach einem der vorangehenden Ansprüche, wobei die Schicht(en) ferner ein lumineszierendes Pigment aufweist/aufweisen.

5. Uhrenkomponente nach einem der vorangehenden Ansprüche, die eine transparente oder halbtransparente Komponente wie eine Spirale, ein Zeiger, ein Glas oder ein Uhrenboden ist.

6. Uhrenkomponente nach einem der Ansprüche 1 bis 4, die eine opake Komponente wie ein Zifferblatt oder ein Organ des Uhrwerks ist.

7. Uhr, umfassend eine Uhrenkomponente nach einem der vorangehenden Ansprüche.

8. Verfahren zum Überziehen einer Uhrenkomponente, die auf mindestens einem Teil ihrer Oberfläche ein Motiv mit oder ohne Relief aufweist, durch Vakuumverdampfen organischer Pigmente, wobei das Motiv durch den Überzug sichtbar ist.

9. Verfahren nach Anspruch 8, wobei die Pigmente aus der Liste ausgewählt sind, die aus Cinophthalon, Disazokondensation, Mononatriumsalz, Isoindolinon, Isoindolin, Azoverbindung, Pteridin, Diarylid, Diketopyrrolopyrrol, Benzimidazolon, Perylen, β-Naphthol (Sr), β-Naphthol (Ba), Anthrachinon, Chinacridon, BONA (Sr), BONA (Ca), Dioxazin und Cu-Phthalocyanin besteht.

10. Verfahren nach Anspruch 8 oder 9, wobei die Pigmente mit einem Lösungsmittel gemischt und in einem Temperaturbereich zwischen 40 und 120 °C, vorzugsweise auf zirka 50 °C, erhitzt werden, um ein kompaktes Pigmentgemisch vor Sublimation zu bilden.

11. Verfahren nach einem der Ansprüche 8 bis 10, umfassend, nach dem Aufbringen der organischen Pigmente, einen Schritt des Aufbringens einer abschließenden Schutzschicht durch Sputtern.

12. Verfahren nach Anspruch 11, wobei die abschließende Schutzschicht eine Oxidschicht ist.

## Claims

1. Timepiece component including on at least one part of its surface a coating formed of one or more layers of organic pigments, **characterised in that** it comprises on at least one part of its surface a pattern with or without relief, visible through the layer or layers.

2. Timepiece component according to claim 1, comprising several layers respectively formed of different pigments, said layers being superposed or positioned at distinct places on the component.

3. Timepiece component according to claim 1 or 2, wherein the pigments are chosen from a list consisting of quinophthalone, disazo condensation, monosodium salt (monoazo), isoindolinone, isoindoline, azo compounds, pteridine, diarylide, diketopyrrolopyrrole, benzimidazolone, perylene, β-naphtol (Sr), β-naphtol (Ba), anthraquinone, quinacridone, BONA (Sr), BONA (Ca), dioxazine, Cu-phthalocyanine.

4. Timepiece component according to any of the preceding claims, wherein the layer or layers further include a luminescent pigment.

5. Component according to any of the preceding claims, being a transparent or semi-transparent component such as a balance spring, a hand, a crystal or a watch case back.

6. Timepiece component according to any of claims 1 to 4, being an opaque component such as a dial or an element of the movement.

7. Watch including a timepiece component according to any of the preceding claims.

8. Method for coating a timepiece component comprising on at least one part of its surface a pattern with or without relief by vacuum evaporation of organic pigments, where said pattern is visible through said coating.

9. Method according to claim 8, wherein the pigments are selected from the list consisting of quinophthalone, disazo condensation, monosodium salt (monoazo), isoindolinone, isoindoline, azo compounds, pteridine, diarylide, diketopyrrolopyrrole, benzimidazolone, perylene, β-naphtol (Sr), β-naphtol (Ba), anthraquinone, quinacridone, BONA (Sr), BONA (Ca), dioxazine, Cu-phthalocyanine.

10. Method according to claim 8 or 9, wherein the pigments are mixed with a solvent and heated in a temperature range comprised between 40 and 120°C and preferably around 50°C, to form a compact mixture of pigments before sublimation.

11. Method according to any of claims 8 to 10, including, after the organic pigment deposition, a step of depositing a final protective layer by cathodic sputtering.

12. Method according to claim 11, wherein the final protective layer is an oxide layer.
